# EUROPEAN PATENT APPLICATION

(11) **EP 4 780 188 A2**
(43) Date of publication of application: **22.07.2026**
(21) Application number: 26174452.8
(22) Date of filing: 10.11.2021
(51) Int. Cl.: H10P 14/692

(54) **METHOD OF FABRICATING A DEVICE HAVING A PASSIVATING LAYER**

(62) Divisional of application: 21819671.5
(71) Applicant: Microsoft Technology Licensing, LLC, Redmond, WA 98052-6399 (US)
(72) Inventor: MARCUS, Charles Masamed, Redmond, 98052-6399 (US); DRACHMANN, Asbjørn Cennet Cliff, Redmond, 98052-6399 (US)
(74) Representative: Page White Farrer

(57) **Abstract**

A method of fabricating a device comprises: fabricating a semiconductor component on a substrate, the semiconductor component comprising one or more nanowires; forming (101) a patterned layer (220) of a material on a surface of a substrate (210) by depositing the material onto the surface through a stencil mask; and forming (102, 103) a passivating layer (240) over the patterned layer (220) and the surface; wherein the method is performed in a sealed apparatus, and the substrate (210) is maintained under a vacuum until after the passivating layer (240) has been formed.

## Description

### Background

Semiconductor nanowires proximitized by a superconductor are expected to host a topological phase of matter, provided the right conditions. This makes them a promising candidate as building blocks of a fault-tolerant quantum computer.

The topological phase manifests itself in the form of a pair of Majorana zero modes ("MZMs") at the ends of the nanowire. Along the bulk of the wire, away from the ends, a gap in the single-electron spectrum is present. Experiments typically use tunnelling spectroscopy at the ends of the nanowire to detect a zero-bias peak ("ZBP") in tunnelling conductance.

By forming a network of such nanowires and inducing the topological regime in parts of the network, it is possible to create a quantum bit which can be manipulated for the purpose of quantum computing. A quantum bit, also referred to as a qubit, is an element upon which a measurement with two possible outcomes can be performed, but which at any given time (when not being measured) can in fact be in a quantum superposition of the two states corresponding to the different outcomes.

A nanowire may take the form of an elongate portion of semiconductor material, having a length dimension many times greater than its width and thickness. A nanowire is a quasi-one-dimensional system. A layer of conventional superconductor is arranged on at least a portion of the nanowire.

Another system useful for generating MZMs is a semiconductor nanowire based on a two-dimensional electron gas ("2DEG") with proximity coupling to a conventional superconductor. The superconductor is typically grown as part of an epitaxial 2D wafer stack but can also be deposited after material growth during fabrication. This material platform has sizable spin-orbit coupling and large electron g-factor, which are key ingredients for the formation of a topological state.

To induce a topological phase, the device is cooled to a temperature where the superconductor (e.g. aluminium) exhibits superconducting behaviour. The superconductor causes a proximity effect in the adjacent semiconductor, whereby a region of the semiconductor near the interface with the superconductor also exhibits superconducting properties, that is, a superconducting pairing gap is induced in the adjacent semiconductor. MZMs are formed at two ends of the semiconductor-superconductor hybrid when a magnetic field is applied.

The role of the magnetic field is to lift the spin degeneracy in the semiconductor. Degeneracy in the context of a quantum system refers to the case where different quantum states have the same energy level. Lifting the degeneracy means causing such states to adopt different energy levels. Spin degeneracy refers to the case where different spin states have the same energy level. Spin degeneracy can be lifted by means of a magnetic field, causing an energy level spilt between the differently spin-polarized electrons. This is known as the Zeeman effect. The Zeeman energy, i.e. the magnitude of the energy level split, should be at least as large as the superconducting gap in order to close the trivial superconducting gap and reopen a topological gap in the system.

Inducing MZMs may also involve adjusting the electrostatic potential of charge carriers in the nanowire by gating the nanowire with an electrostatic potential. The electrostatic potential is applied using a gate electrode. Applying an electrostatic potential manipulates the number of charge carriers in the conductance band or valence band of the semiconductor component.

The properties of hybrid structures are highly dependent upon the quality of the interface between the semiconductor component and the superconductor component. Significant material science advances have been made to enable pristine coupling between semiconductors and superconductors. One hybrid platform is aluminum grown on indium arsenide.

Kanne et al (Nature Nanotechnology, vol. 16, pp. 776-781) have described the growth of lead (Pb) on vapor-liquid-solid nanowires. Lead has a much larger superconductive gap than aluminium, making it an attractive candidate for inclusion in hybrid structures. Thin films of lead are however fragile, and consequently would be destroyed by many post-fabrication processes.

### Summary

In one aspect, there is provided a method of fabricating a device. The method comprises: forming a patterned layer of a material on a surface of a substrate by depositing the material onto the surface through a stencil mask; and forming a passivating layer over the patterned layer and the surface. The method is performed in a sealed apparatus, and the substrate is maintained under a vacuum until after the passivating layer has been formed.

By maintaining the substrate under a vacuum, contamination of and damage to the surface of the substrate may be avoided. Further, since a stencil mask is used to pattern the deposited material, it is not necessary to form a lithographic mask on the substrate, or to perform *ex situ* etching. The method can be performed at low temperatures, thereby avoiding degradation of the substrate and patterned layer.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter. Nor is the claimed subject matter limited to implementations that solve any or all of the disadvantages noted herein.

### Brief Description of the Drawings

To assist understanding of embodiments of the present disclosure and to show how such embodiments may be put into effect, reference is made, by way of example only, to the accompanying drawings in which:
Fig. 1 is a flow diagram outlining a method of fabricating a device;
Figs. 2A to 2C are schematic cross-sections of workpieces obtained at various steps of the method of Fig. 1; and
Fig. 3 is a block diagram of an example apparatus useful for performing the method.

### Detailed Description of Embodiments

The verb 'to comprise' is used herein as shorthand for 'to include or to consist of'. In other words, although the verb 'to comprise' is intended to be an open term, the replacement of this term with the closed term 'to consist of' is explicitly contemplated, particularly where used in connection with chemical compositions.

Directional terms such as "top", "bottom", "left", "right", "above", "below", "horizontal" and "vertical" are used herein for convenience of description and relate to the orientation shown in the relevant drawing. For the avoidance of any doubt, this terminology is not intended to limit orientation in an external frame of reference.

As used herein, the term "superconductor" refers to a material which becomes superconductive when cooled to a temperature below a critical temperature, T_{c}, of the material. The use of this term is not intended to limit the temperature of the device.

A "nanowire" is an elongate member having a nano-scale width, and a length-to-width ratio of at least 100, or at least 500, or at least 1000. A typical example of a nanowire has a width in the range 10 to 500 nm, optionally 50 to 100 nm or 75 to 125 nm. Lengths are typically of the order of micrometres, e.g. at least 1 µm, or at least 10 µm.

A "semiconductor-superconductor hybrid structure" comprises a semiconductor component and a superconductor component, and is configured such that the superconductor component is capable of inducing superconductivity in the semiconductor component by proximity effect under certain operating conditions. In particular, this term refers to a structure capable of showing topological behaviour such as Majorana zero modes, or other excitations useful for quantum computing applications. The operating conditions generally comprise cooling the structure to a temperature below the critical temperature of the superconductor component, applying a magnetic field to the structure, and applying electrostatic gating to the structure. Generally, at least part of the semiconductor component is in intimate contact with the superconductor component. For example, the superconductor component may be epitaxially grown on the semiconductor component. Certain device structures having one or more further components between the semiconductor component and superconductor component have however been proposed.

A "topological insulator-superconductor hybrid structure" differs from semiconductor-superconductor hybrid structure in that the semiconductor component is replaced with a topological insulator component. Electrostatic gating of topological insulator-superconductor hybrid structures is not usually required. Furthermore, the application of a magnetic field is also not usually required, since spin-momentum locking provides spin polarization.

As used herein, a "vacuum" is an environment having a gas pressure of less than or equal to 1 x 10⁴ Pa. A "medium vacuum" is an environment having a gas pressure in the range 3 kPa to 0.1 Pa. An "ultra-high vacuum" is an environment having a pressure of less than or equal to 100 nanopascal.

Provided herein is a method of fabricating a device which includes a patterned thin film on a substrate. The thin film is patterned *in situ,* using a stencil mask or the like, rather than through the use of *ex-situ* etching or lift-off. A passivating layer is then formed *in situ* over the thin film. By patterning the film and forming the passivating layer *in situ,* a pristine interface between the thin film and the substrate may be obtained. The passivating layer protects the thin film and the surface of the substrate from damage during any subsequent post-fabrication operations, in particular any post-fabrication etching processes. Further, in some implementations, the method may be performed at low temperature to prevent dewetting of the thin film from the substrate.

Although the method will be described with particular reference to the fabrication of semiconductor-superconductor hybrid structures, in which the substrate comprises a semiconductor and the patterned layer comprises a superconductor, the method may be applied to other combinations of materials and to the fabrication of other devices. The patterned layer may comprise any thin film or combination of thin films which can be grown on the substrate, for example a superconductor, semiconductor, metal, and/or ferromagnet.

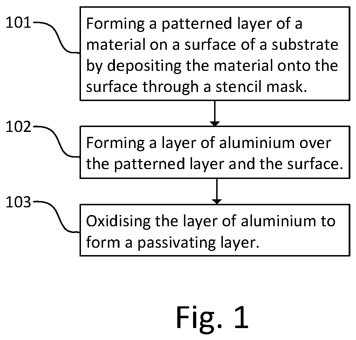

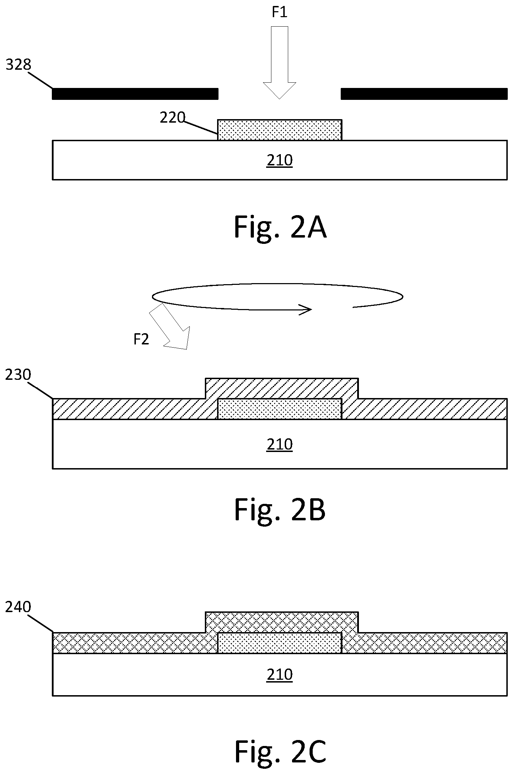

An example method will now be described with reference to Figs. 1 and 2A to 2C. Fig. 1 is a flow diagram outlining the method, and Figs. 2A to 2C illustrate workpieces obtained at various stages of the method.

At block 101, a patterned layer of a material is formed on a substrate by depositing material onto the substrate through a stencil mask. This operation is illustrated in Fig. 2A.

The nature of the substrate 210 is not particularly limited. The substrate 210 typically includes at least a wafer, i.e. a piece of single crystalline material. The wafer provides a physical support and growth medium for further components. The wafer typically comprises a high bandgap semiconductor material. Examples of wafer materials include indium phosphide, indium antimonide, indium arsenide, gallium arsenide, gallium phosphide and silicon.

The substrate 210 may include a semiconductor component.

For example, the semiconductor component may comprise a nanowire. The nanowire may be a selective-area-grown ("SAG") nanowire. A plurality of such nanowires may be present, and the nanowires may be arranged in a network.

The nanowire may comprise a III-V semiconductor material, in particular a material of Formula 1:

InAsₓSb₁₋ₓ

where x is in the range 0 to 1. In other words, the nanowire may comprise indium antimonide (x=0), indium arsenide (x=1), or a ternary mixture comprising 50 % indium on a molar basis and variable proportions of arsenic and antimony (0 <x <1).

Another class of useful semiconductor materials are the II-VI semiconductor materials. Examples of II-VI semiconductor materials include cadmium telluride, mercury telluride, lead telluride and tin telluride.

The semiconductor component may comprise a semiconductor heterostructure configured to host a two-dimensional electron gas ("2DEG") or a two-dimensional hole gas ("2DHG"). A semiconductor heterostructure comprises a quantum well arranged between a lower barrier and an upper barrier. The quantum well comprises a material which is different from the material(s) of the lower barrier and upper barrier. The materials of the lower barrier and the upper barrier may each be independently selected.

The configuration of the lower and upper barriers is not particularly limited, provided that these layers allow the charge carriers (electrons or holes) to be trapped in the quantum well. The lower barrier may comprise one or more layers of one or more different materials. The upper barrier may comprise one or more layers of one or more different materials. Constructing a barrier from a plurality of layers may provide defect filtering, i.e. may reduce the effects of dislocations in the crystalline structure of the materials used.

The quantum well may comprise a layer of semiconductor material which has a relatively small band gap compared to the materials of the lower and upper barriers. Illustrative materials useful for forming quantum wells are described in, for example, Odoh and Njapba, "A Review of Semiconductor Quantum Well Devices", Advances in Physics Theories and Applications, vol. 46, 2015, pp. 26-32; and S. Kasap, P. Capper (Eds.), "Springer Handbook of Electronic and Photonic Materials", DOI 10.1007/978-3-319-48933-9_40.

As an alternative to a semiconductor component, or in addition to a semiconductor component, the substrate may include a topological insulator component. A topological insulator is a material which has an electrically-conductive surface and an electrically-insulating bulk. One useful class of topological insulator materials is defined by Formula 2:

(Bi_{1-y}Sb_{y})₂Te₃

where y is in the range 0 to 1. In particular, y may be in the range 0.5 to 1, 0.6 to 0.9, or 0.8 to 0.9.

The substrate may be prepared in the same apparatus as that which is used to perform the present method. Preparing the substrate may include cleaning the wafer to remove adsorbed contaminants. Preparing the substrate may include growing any semiconductor component(s) and/or topological insulator components on the wafer. The growth may, for example, be controlled by the use of a stencil mask. By preparing the substrate in the same apparatus, exposure of the substrate to the open atmosphere may be avoided. This may prevent contamination of the surface of the substrate and/or avoid chemical degradation of the materials used, thereby improving the quality of the finished device. The properties of semiconductor-superconductor hybrid devices in particular are sensitive to the quality of the interface between the semiconductor component and the superconductor component.

The nature of the material used to form the patterned layer 220 is not particularly limited, provided that the material can be deposited on the substrate 210.

The material of the patterned layer may be a metal.

The metal may be a superconductor. Examples of superconductive metals include aluminium and lead. Aluminium and lead both have good compatibility with the semiconductor materials of Formula 1.

The metal may be a normal metal. Normal metals are useful for forming electrical connectors or contact pads, for example. Examples of normal metals include titanium and gold. A further example is a chromium/gold bilayer.

Lead may be particularly useful in some implementations, because it has a very large superconductive gap, Δ. Hybrid devices which incorporate lead may therefore have a large topological gap. This means that Majorana zero modes formed in such a device may be better protected against thermal variations and the like, allowing more reliable quantum computation. Water etches lead, and thin films of lead are easily damaged by water vapour. The passivating layer formed later in the method may protect the lead layer from damage.

In examples where the substrate includes a topological insulator which is a tellurium compound, in particular a compound of Formula 2, the material may be palladium. It has been reported that when palladium is deposited onto a compound of Formula 2, a superconductive compound, PdTe₂, is formed at the interface between the palladium layer and the topological insulator.

The material of the patterned layer may be a ferromagnetic insulator, for example a material selected from EuS, EuO, GdN, Y₃Fe₅O₁₂, Bi₃Fe₅O₁₂, YFeO₃, Fe₂O₃, Fe₃O₄, Sr₂CrReO₆, CrBr₃/CrI₃, and YTiO₃. In particular, the ferromagnetic insulator material may be EuS or EuO. These materials can be deposited at low temperatures.

The material of the patterned layer may be a barrier material such as those described in US 2021/0126181 A1. Examples of barrier materials include materials of Formula 3:

In_{1-z}Al_{z}As

where z is in the range of 0.05 to 1.

Further examples of barrier materials include materials of Formula 4:

AlₙGa₍₁₋ₙ₎Sb

where n is in the range 0.04 to 0.9.

Where a ferromagnetic insulator layer or barrier layer is present, the patterned layer 220 typically further includes a layer of superconductor material.

The material of the patterned layer 220 may comprise a complex oxide. A complex oxide is a compound of oxygen and at least two other elements. One example of a complex oxide is strontium titanate, SrTiO₃. SrTiO₃ may host a high-density 2-dimensional electron gas, and has useful magnetic properties.

Although the example illustrates a single patterned layer 220, methods which include forming two or more patterned layers are also contemplated. Different stencil masks may optionally be used for individual ones of the layers, depending upon the design of the device to be fabricated. The use of individually selected stencil masks may allow different materials to be deposited at different locations on the substrate, allowing further degrees of freedom for device design.

Where the present method is used to fabricate a hybrid device, the patterned layers may include:
a layer of semiconductor or topological insulator, if not prepared in advance as part of the substrate;
optionally, a layer of ferromagnetic insulator or barrier material; and
a layer of superconductor material.

Where the present method is used to form a layer of superconductor material, two or more layers of two or more different superconductors may be deposited. For example, a layer of aluminium may be deposited first, followed by a layer of lead on top of the layer of aluminium. This may improve the coupling of the lead layer to the substrate, as described in WO 2021/113746 A1.

As illustrated in Fig. 2A, the layer of patterned material 220 is deposited through an opening in a stencil mask 328. A flux of material F1, for example a beam of material from an evaporator, passes through the opening and arrives at the surface of the substrate.

The use of a stencil mask allows the layer to be patterned without the need to apply a resist to the surface of the substrate, as in comparative techniques such as lift-off or lithography with etching. The patterning is therefore achieved in the growth chamber in which the layer is fabricated. The substrate is not exposed to the open atmosphere, and the surface of the substrate remains pristine. This may allow a higher quality device to be obtained.

During the deposition of the patterned layer, the substrate may be maintained at a temperature of less than or equal to 273 K (0°C), for example a temperature in the range 50 to 100 K. Thin films of metal can dewet from the substrate if their temperature becomes too high. As used herein, dewetting refers to a process whereby a continuous film breaks apart into isolated blobs. It has been found that applying a passivating layer over a metal film while the metal film is cold may reduce dewetting and may allow the device then to tolerate higher temperatures during subsequent processing steps.

The patterned layer is formed by a directional deposition process, which is typically a physical deposition process. In particular, the patterned layer may be formed by evaporation, optionally via a molecular beam epitaxy process. Physical deposition onto a low temperature substrate (e.g., a substrate at a temperature of 0°C or below) is possible for many materials.

After forming the patterned layer, a passivating layer is formed over the patterned layer and over the surface of the substrate. In this example, the passivating layer is an aluminium oxide layer which is formed in two operations.

At block 102, a layer of aluminium is formed over the patterned layer and over the surface of the substrate. This operation is illustrated in Fig. 2B.

The layer of aluminium 230 is deposited over the entire surface of the substrate 210, and covers the patterned layer. This may be referred to as a "global deposition". The deposition may comprise growing the aluminium layer by molecular beam epitaxy.

The layer of aluminium 230 may be fabricated in the same growth chamber as the patterned layer. To allow this, the stencil mask 328 may be moved away from the substrate so as not to interfere with the flux F2 of aluminium. For example, the stencil mask may be rotated to a vertical position, or placed to one side, or removed from the growth chamber via an airlock.

Alternatively, the layer of aluminium 230 may be fabricated in a different growth chamber of the sealed apparatus. In such implementations, the substrate is moved between the growth two chambers while maintaining the substrate in a vacuum, preferably an ultra-high vacuum. Growth chambers can be coupled together via valves, and optionally via a buffer chamber which acts as an airlock.

In implementations where a directional deposition process is used to grow the aluminium layer, the patterned layer may cast shadows over portions of the substrate surface. In other words, the patterned layer may block the beam of deposited material. The aluminium layer may consequently have an uneven thickness. Shadowing may be observed if the thickness of the patterned layer 220 is greater than about 10 nm.

To reduce the effects of shadowing, the direction of the beam of aluminium with respect to the surface of the substrate may be varied during the growth of the layer. The substrate may be moved, e.g. rotated or tilted. The beam source may be moved. Alternatively, a plurality of beams of material may be applied from a plurality of different directions, either simultaneously or sequentially.

The thickness of the layer of aluminium 230 may be less than or equal to 3 nm, for example in the range 2 to 3 nm. Aluminium layers having thicknesses of about 3 nm or less can be conveniently oxidized fully by exposure to oxygen gas.

During deposition of the aluminium, the temperature of the substrate may be maintained at a temperature of less than or equal to 273 K (0°C), for example a temperature in the range 50 to 100 K. As discussed above, maintaining the substrate at a low temperature may help to prevent dewetting of the patterned layer from the substrate. The temperature of the substrate may be assumed to be equal to the temperature of a sample stage which holds the substrate.

The aluminium layer is typically formed by a physical deposition process. In particular, the aluminium layer may be formed by evaporation, optionally via a molecular beam epitaxy process. Aluminium evaporates at a relatively low temperature, and physical deposition of aluminium onto a cold substrate has been found to proceed well.

Subsequently, at block 103, the aluminium layer 230 is oxidised. This converts the aluminium layer into a passivating layer of aluminium oxide 240, as illustrated in Fig. 2C.

The oxidation may comprise exposing the aluminium layer to oxygen gas. The oxygen gas may be at a pressure in the range in the range 0.1 to 10 Pa, e.g. 0.5 to 1.5 Pa. Exposing the aluminium to oxygen gas at pressure of about 1 Pa provides a convenient way to perform the oxidation.

The extent of the oxidation may be controlled by selecting the pressure of the oxygen gas and the temperature at which the oxidation is performed. Generally, it is desirable to oxidise fully the aluminium layer 230 deposited at operation 102. Aluminium will undergo self-limiting oxidation when exposed to oxygen gas. By way of illustration, an aluminium oxide layer having a depth of about 3 nm forms when aluminium is exposed to the atmosphere.

The oxidation is typically started soon after completing deposition of the aluminium layer 230, while the substrate is still cold (e.g., at a temperature less than 273 K, optionally less than 200 K). For example, the oxidation may be started within an hour of completing the deposition, optionally within 30 minutes, further optionally within 10 minutes, further optionally within 5 minutes. Since the substrate is maintained in a vacuum, heat transfer to the substrate is generally slow, since there will be very little conduction or convection.

Keeping the substrate cold until the aluminium layer has at least partially oxidized may help to avoid dewetting.

The temperature of the substrate may be allowed to increase during the oxidation process, since once an initial oxide layer is formed, the patterned layer may be protected from dewetting. The initial temperature of the substrate may be in the range 50 to 100 K. The final temperature may be up to 303 K (30 °C). Allowing a temperature increase may increase the depth to which the aluminium layer oxidises.

Forming an aluminium layer and then oxidising the aluminium layer *in situ* allows a passivating layer to be formed without exposing the substrate to high temperatures. This allows for the passivation of temperature-sensitive thin films.

Once formed, the passivating aluminium oxide layer 240 protects the patterned layer 220 and the substrate 210, including any semiconductor or topological insulator components. This allows for post-fabrication operations to be performed without damaging the patterned layer or substrate, and also without degrading the interface between the patterned layer and the substrate.

Various modifications may be made to the example method.

Although the described example makes use of an aluminium oxide passivating layer, passivating layers formed from other materials may be used.

For example, block 102 may be modified to comprise depositing a layer of dielectric material in situ onto the substrate. In such implementations, the operations of block 103 are omitted. If the patterned layer and substrate are not temperature-sensitive, atomic layer deposition of a dielectric material may be performed. Atomic layer deposition generally involves heating the substrate to a temperature of at least 350 K.

In another example, a different metal may be substituted for the aluminium layer formed at block 102. At block 103, the metal may be converted into a passivating material using any appropriate reagent, not necessarily oxygen.

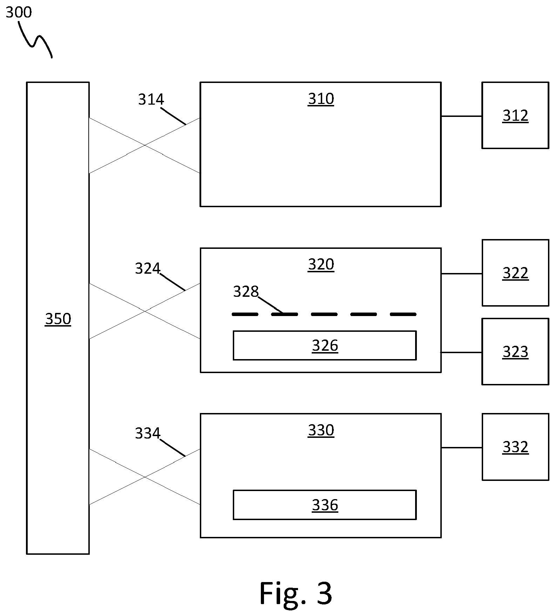

An example apparatus 300 useful for implementing the method will now be described with reference to Fig. 3. Fig. 3 is a block diagram of the apparatus.

Apparatus 300 includes a set of vacuum chambers 310, 320, 330. These vacuum chambers are referred to as working chambers. The vacuum chambers are each connected to a buffer chamber 350 via respective gate valves 314, 324, 334. This allows a substrate to be moved between the vacuum chambers without being exposed to the open atmosphere. By connecting working chambers via a buffer chamber, the unwanted transfer of reagents between the working chambers may be prevented.

In this example, the first working chamber 310 may be configured to allow fabrication of a semiconductor component on a wafer, and is in communication with a material source 312 for providing semiconductor material, or a suitable precursor thereof, for deposition on the wafer.

The second working chamber 320 is configured to allow the operations of blocks 102 and 103 of Fig. 1 to be performed. The second working chamber may be a molecular beam epitaxy chamber. The second working chamber 320 is configured to provide an ultra-high vacuum environment.

In this example, the second working chamber 320 is in communication with two material sources 322, 323. First material source 322 may be an evaporator for providing a material such as lead to be deposited in a patterned layer. Second material source 323 may be an evaporator for providing a material for forming the passivating layer, e.g. aluminium.

A cooling plate 326 for cooling the substrate is arranged in the second working chamber 320. The cooling plate may include one or more tubes, and liquid nitrogen may be pumped through the tubes to cool the substrate.

The substrate may be mounted on a sample carrier. The sample carrier may be configured to act as a heat sink, i.e. may comprise a material having a relatively high specific heat capacity. This may help to maintain the substrate at a low temperature as it is being moved between chambers.

A stencil mask 328 is also arranged in the second working chamber. The stencil mask may be movable using a manipulator, such that the stencil mask may be positioned over the substrate when desired. The stencil mask is useful for patterning a layer of material, as described with reference to block 101 of Fig. 1.

The third working chamber 330 of this example is configured as an oxidation chamber for oxidising an aluminium layer, as described with reference to block 103 of Fig. 1. The third vacuum chamber is connected to an oxygen gas supply 332. The third vacuum chamber and oxygen gas supply 332 may together be configured to provide an environment having an oxygen gas pressure of 0.1 to 10 pascals, optionally 0.5 to 5 pascals. A cooling plate 336 for controlling the temperature of the substrate during the oxidation is provided in this chamber.

Various modifications may be made to the example apparatus.

The apparatus may include two separate working chambers for fabrication of the patterned layer and the aluminium layer, respectively.

In variants where a material other than aluminium oxide is to be used as the passivating layer, oxidation chamber 330 may be omitted.

Additional chambers for preparing the substrate may be included in the apparatus.

It will be appreciated that the above embodiments have been described by way of example only.

More generally, according to one aspect disclosed herein, there is provided a method of fabricating a device. The method comprises forming a patterned layer of a material on a surface of a substrate by depositing the material onto the surface through a stencil mask; and forming a passivating layer over the patterned layer and the surface. The method is performed in a sealed apparatus, and the substrate is maintained under a vacuum until after the passivating layer has been formed.

The method is particularly useful for the fabrication of components for a quantum computer.

For example, the device may include a semiconductor-superconductor hybrid structure and/or a topological insulator-superconductor hybrid structure. Since the present method may allow a pristine interface between the patterned layer and substrate, the method may allow higher quality hybrid structures to be obtained. The passivating layer may also provide good protection to the hybrid structure during any post-fabrication processing, e.g. the addition of gate electrodes.

The device may include a superconductive circuit. The device may include one or more Josephson junctions.

By maintaining the substrate under a vacuum, contamination of the surface of the substrate may be avoided. Damage to materials which can be chemically degraded by air or water vapour may also be avoided. The vacuum may be an environment having a gas pressure of less than or equal to 1 x 10⁴ Pa. Deposition operations are typically performed under an ultra-high vacuum. Oxidation operations may be performed under a medium vacuum.

Since a stencil mask is used to pattern the deposited material, it is not necessary to form a lithographic mask on the substrate. The use of etching is also avoided. This may avoid degradation and/or contamination of the patterned layer and of the surface of the substrate.

The patterned layer and passivating layer are formed without applying a resist to the substrate. The patterned layer and passivating layer are formed without the use of etching. The patterned layer and passivating layer are formed without the use of electron beam lithography. The patterned layer and passivating layer are formed without the use of a lift-off process.

The patterned layer may be formed by physical deposition, e.g. evaporation, of the material.

The passivating layer may be formed by physical deposition, e.g. evaporation. The passivating layer may be formed by physical deposition of a precursor (e.g., aluminium), followed by *in situ* conversion (e.g., oxidation) of the precursor into a passivating material (e.g., aluminium oxide). The use of physical deposition may allow the substrate to be maintained at a low temperature during the method.

Forming the passivating layer may comprise forming a layer of aluminium over the patterned layer and the surface; and oxidising the layer of aluminium to form the passivating layer. The layer of aluminium may be deposited by evaporation. For example, the layer of aluminium may be grown over the patterned layer and the surface of the substrate by molecular beam epitaxy. Usefully, aluminium can be evaporated at a relatively low temperature. This may allow the substrate to be maintained at a low temperature during formation of the aluminium layer, which may help to prevent dewetting of the patterned layer from the substrate. The oxidation of the aluminium layer may also be performed at a low temperature.

Oxidizing the layer of aluminium may comprise exposing the layer of aluminium to oxygen gas having a pressure in the range 0.1 Pa to 3 kPa, optionally 0.1 to 10 Pa, further optionally 0.5 to 5 Pa. An environment with a gas pressure in the range 0.1 Pa to 3 kPa is regarded as a medium vacuum. The oxidation may be performed at a temperature of less than or equal to 30°C.

The oxidation of the aluminium layer may be performed while the substrate is cold. The temperature of the substrate may increase during the oxidation. The initial temperature of the substrate may be in the range in the range 50 to 150 K. The final temperature of the substrate during the oxidation is typically less than or equal to 30°C (303 K), and is optionally less than or equal to 0°C (273 K). Maintaining the substrate at a low temperature until the aluminium layer is at least partially oxidized may prevent dewetting of the patterned layer.

The layer of aluminium may have a thickness of less than or equal to 3 nm, optionally less than or equal to 2 nm. For example, the layer of aluminium may have a thickness in the range 1 to 3 nm, optionally 1 to 2 nm.

The direction from which the material which forms the passivating layer is supplied may be varied during the formation of the passivating layer. For example, the method may further comprise rotating and/or tilting the substrate during the formation of the passivating layer. This may allow a passivating layer having a more even thickness to be obtained.

The material of the patterned layer may be a superconductor material. The superconductor material may be selected from lead and aluminium.

Lead has a superconductive gap which is about 6 times the size of aluminium's superconductive gap. A large superconductive gap is a desirable property for superconductor components of hybrid devices. However, thin films of lead are very susceptible to damage, and for example can be etched by water. The present method allows a passivating layer to be formed in *situ* over the lead. The passivating layer may protect the lead layer, for example during any post-fabrication processes.

Aluminium is reported to couple strongly to semiconductor materials of Formula 1. The strength of the coupling may vary depending on the thickness of the aluminium layer. The thickness may be in the range 4 to 10 nm, for example. Thin films can be susceptible to dewetting when exposed to elevated temperatures. The methods provided herein may be performed at low temperature, which may reduce or avoid dewetting.

Forming the patterned layer may comprise growing the patterned layer by molecular beam epitaxy.

The patterned layer and the passivating layer may both be performed in the same vacuum chamber. This may reduce the risk of contaminating the patterned layer and the surface of the substrate.

Alternatively, patterned layer may be formed in a first vacuum chamber of the sealed apparatus, and the method may further comprise transferring the substrate from the first vacuum chamber to a second vacuum chamber after forming the patterned layer and before forming the passivating layer.

The thickness of the patterned layer is not particularly limited. Since the present method may be performed without exposing the substrate to high temperatures, the method may be particularly useful for thin patterned layers which may be susceptible to dewetting on exposure to excessive heat. For example, the patterned layer may have a thickness of less than or equal to 10 nm, optionally less than or equal to 5 nm.

The substrate may be maintained at a temperature of less than or equal to 273 K (0°C) until after the passivating layer has been formed. In particular, the substrate may be maintained at a temperature in the range 50 to 100 K. Maintaining the substrate at a low temperature, at least until after the passivating layer has been deposited, may prevent dewetting of the patterned layer.

The patterned layer may be formed while the substrate is at a temperature in the range 50 to 100 K. The aluminium layer may be deposited while the substrate is at a temperature in the range 50 to 100 K. Oxidation of the aluminium layer may be performed while the substrate is at a temperature of less than or equal to 273 K.

The substrate may include a semiconductor component. For example, the substrate may comprise a wafer and a semiconductor component arranged on the wafer.

In implementations where a semiconductor component is present, the method may further comprise, before forming the patterned layer, fabricating the semiconductor component in the sealed apparatus. This may avoid contamination of the surface of the semiconductor component, thereby allowing a better interface between the semiconductor component and the patterned layer to be formed. A stencil mask may be used to control the growth of the semiconductor component.

The semiconductor component may comprise one or more nanowires. The nanowires may be SAG nanowires.

The semiconductor component may comprise a heterostructure configured to host a 2-dimensional electron gas or a 2-dimensional hole gas. The heterostructure may comprise a quantum well layer arranged between two barrier layers.

The semiconductor component may comprise a material of Formula 1:

InAsₓSb₁₋ₓ

where x is in the range 0 to 1. The material may be indium arsenide (x=1). Further examples of materials of Formula 1 include those wherein x is in the range 0 to 0.7, or 0.01 to 0.7, or 0.35 to 0.45.

As an alternative to a semiconductor component, or in addition to a semiconductor component, the substrate may include a topological insulator. Without wishing to be bound by theory, it may be possible to induce computationally-useful excitations (e.g., Majorana zero modes) in a topological insulator-superconductor hybrid device without necessarily requiring electrostatic gating of the topological insulator.

Examples of topological insulator materials include HgTe, Bi₂Te₃, Bi₂Se₃, Sb₂Te₃, CsPbI₃ and CsSnI₃. The topological insulator material may be a tellurium compound, such as a material of Formula 2:

(Bi_{1-y}Sb_{y})₂Te₃

where y is in the range 0 to 1, optionally 0.5 to 1, 0.6 to 0.9, or 0.8 to 0.9.

In implementations where the topological insulator is a tellurium compound, and particularly in implementations where the topological insulator is a compound of Formula 2, the material of the patterned layer may be palladium. Depositing palladium onto such a material may result in the formation of a superconductive layer of PdTe₂ at the interface with the topological insulator material.

After forming the passivating layer, the substrate may be removed from the sealed apparatus. The passivating layer may protect the patterned layer and the surface of the substrate from degradation by air or water vapour. Post-fabrication processes may be performed. For example, gate electrodes may be added to the device. The passivating layer may protect the patterned layer and the surface of the substrate from damage during the post-fabrication processes. For example, the passivating layer may protect the patterned layer and the surface of the substrate from damage by any post-fabrication etching processes.

Other variants or use cases of the disclosed techniques may become apparent to the person skilled in the art once given the disclosure herein. The scope of the disclosure is not limited by the described embodiments but only by the accompanying claims.

The present disclosure provides the following clauses:
Clause 1. A method of fabricating a device, which method comprises:
   forming a patterned layer of a material on a surface of a substrate by depositing the material onto the surface through a stencil mask; and
   forming a passivating layer over the patterned layer and the surface;
   wherein the method is performed in a sealed apparatus, and the substrate is maintained under a vacuum until after the passivating layer has been formed.
Clause 2. The method according to clause 1, wherein forming the passivating layer comprises:
   forming a layer of aluminium over the patterned layer and the surface; and
   oxidising the layer of aluminium to form the passivating layer;
   optionally wherein the layer of aluminium has a thickness in the range 1 to 3 nm.
Clause 3. The method according to clause 1 or clause 2, wherein forming the patterned layer comprises growing the patterned layer by molecular beam epitaxy.
Clause 4. The method according to any preceding clause, wherein forming the patterned layer and forming the passivating layer are both performed in the same vacuum chamber.
Clause 5. The method according to any of clauses 1 to 3, wherein the patterned layer is formed in a first vacuum chamber of the sealed apparatus, and the method further comprises transferring the substrate from the first vacuum chamber to a second vacuum chamber after forming the patterned layer and before forming the passivating layer.
Clause 6. The method according to any preceding clause, further comprising rotating and/or tilting the substrate during the formation of the passivating layer.
Clause 7. The method according to any preceding clause, wherein the substrate is maintained at a temperature of less than or equal to 273 K, optionally wherein the substrate is maintained at a temperature in the range 50 to 100 K.
Clause 8. The method according to any preceding clause, wherein the material is a superconductor material, optionally wherein the superconductor material is selected from lead and aluminium.
Clause 9. The method according to any preceding clause, wherein the substrate includes a semiconductor component,
   optionally wherein the method further comprises, before forming the patterned layer, fabricating the semiconductor component in the sealed apparatus.
Clause 10. The method according to clause 9, wherein the semiconductor component comprises one or more nanowires.
Clause 11. The method according to clause 9 or clause 10, wherein the semiconductor component comprises a heterostructure configured to host a 2-dimensional electron gas or a 2-dimensional hole gas.
Clause 12. The method according to any of clauses 9 to 11, wherein the semiconductor component comprises a material of Formula 1:

   InAsₓSb₁₋ₓ

   where x is in the range 0 to 1.
Clause 13. The method according to any preceding clause, wherein the substrate includes a topological insulator.
Clause 14. The method according to clause 13, wherein the topological insulator is a tellurium compound, optionally wherein the topological insulator is a material of Formula 2:

   (Bi_{1y}Sb_{y})₂Te₃

   where y is in the range 0.6 to 0.9.
Clause 15. The method according to clause 13 or clause 14, wherein the material of the patterned layer is palladium.

## Claims

1. A method of fabricating a device, which method comprises:
fabricating a semiconductor component on a substrate, the semiconductor component comprising one or more nanowires;
forming a patterned layer of a material on a surface of the substrate by depositing the material onto the surface through a stencil mask; and
forming a passivating layer over the patterned layer and the surface;
wherein the method is performed in a sealed apparatus, and the substrate is maintained under a vacuum until after the passivating layer has been formed.

2. The method according to claim 1, wherein forming the passivating layer comprises:
forming a layer of aluminium over the patterned layer and the surface; and
oxidising the layer of aluminium to form the passivating layer.

3. The method according to claim 2, wherein the layer of aluminium has a thickness in the range 1 to 3 nm.

4. The method according to any preceding claim, wherein forming the patterned layer comprises growing the patterned layer by molecular beam epitaxy.

5. The method according to any preceding claim, wherein forming the patterned layer and forming the passivating layer are both performed in the same vacuum chamber.

6. The method according to any of claims 1 to 4, wherein the patterned layer is formed in a first vacuum chamber of the sealed apparatus, and the method further comprises transferring the substrate from the first vacuum chamber to a second vacuum chamber after forming the patterned layer and before forming the passivating layer.

7. The method according to any preceding claim, further comprising rotating and/or tilting the substrate during the formation of the passivating layer.

8. The method according to any preceding claim, wherein the substrate is maintained at a temperature of less than or equal to 273 K.

9. The method according to claim 8, wherein the substrate is maintained at a temperature in the range 50 to 100 K.

10. The method according to any preceding claim, wherein the material is a superconductor material, optionally wherein the superconductor material is selected from lead and aluminium.

11. The method according to any preceding claim, wherein the semiconductor component comprises a heterostructure configured to host a 2-dimensional electron gas or a 2-dimensional hole gas.

12. The method according to any preceding claim, wherein the semiconductor component comprises a material of Formula 1:
InAsₓSb₁₋ₓ
where x is in the range 0 to 1.

13. The method according to any preceding claim, wherein the substrate includes a topological insulator.

14. The method according to claim 13, wherein the topological insulator is a tellurium compound, optionally wherein the topological insulator is a material of Formula 2:
(Bi_{1y}Sb_{y})₂Te₃
where y is in the range 0.6 to 0.9.

15. The method according to claim 13 or claim 14, wherein the material of the patterned layer is palladium.
